# EUROPEAN PATENT APPLICATION

(11) **EP 2 421 048 A1**
(43) Date of publication of application: **22.02.2012**
(21) Application number: 10764534.3
(22) Date of filing: 16.04.2010
(51) Int. Cl.: H01L 29/786, C23C 14/08, C23C 14/58, H01L 21/336, H01L 21/363

(54) **THIN FILM TRANSISTOR AND METHOD FOR MANUFACTURING THIN FILM TRANSISTOR**

(30) Priority: 17.04.2009 JP 2009101005; 17.04.2009 JP 2009101020; 29.05.2009 JP 2009130965
(71) Applicant: Bridgestone Corporation, Tokyo 104-8340 (JP)
(72) Inventor: SHIINO Osamu, Kodaira-shi Tokyo 187-8531 (JP); SUGIE Kaoru, Kodaira-shi Tokyo 187-8531 (JP); IWABUCHI Yoshinori, Kodaira-shi Tokyo 187-8531 (JP)
(74) Representative: Lamb, Martin John Carstairs
(86) International application number: PCT/JP2010/056850
(87) International publication number: WO 2010/119952

(57) **Abstract**

Disclosed is a thin film transistor comprising elements, namely a source electrode, a drain electrode, a gate electrode, a channel layer and a gate insulating film, said thin film transistor being **characterized in that** the channel layer is formed of an indium oxide film that is doped with tungsten and zinc and/or tin. (2) Disclosed is a bipolar thin film transistor comprising elements, namely a source electrode, a drain electrode, a gate electrode, a channel layer and a gate insulating film, said bipolar thin film transistor being **characterized in that** the channel layer is a laminate of an organic material film and a metal oxide film that contains indium doped with at least one of tungsten, tin or titanium and has an electrical resistivity that is controlled in advance. (3) Disclosed is a method for manufacturing a thin film transistor comprising elements, namely a source electrode, a drain electrode, a gate electrode, a channel layer and a gate insulating film, said method for manufacturing a thin film transistor being **characterized in that** at least the channel layer or a part of the channel layer is formed by forming a metal oxide film by a sputtering process using an In-containing target without heating the substrate, and a heat treatment is carried out after forming the above-described elements on the substrate.

## Description

### TECHNICAL FIELD

The present invention relates to a method for manufacturing a thin film transistor wherein a channel layer or a part thereof and, further, electrodes such as a source electrode, a drain electrode, and a gate electrode are formed of an indium-containing metal oxide film.

### BACKGROUND ART

Hitherto, amorphous silicon (a-Si) has been often used in thin film transistors, and, therefore, a high-temperature process and an expensive film forming apparatus are needed. In addition, the need for a high-temperature process makes it difficult to fabricate a device (element) onto a polymer substrate or the like.

Accordingly, in order to fabricate an electronic device on a polyethylene terephthalate (PET) at low cost, it is indispensable to develop a simple low-temperature process not needing a complicated apparatus, or a material or materials enabling to obtain sufficient characteristics through a simple process, an effective combination of the materials, and, further, a simple device structure, etc.

Here, oxide semiconductors, particularly transparent oxide semiconductors, are materials which are indispensable to realization of an electro-optical device having new characteristics. Recently, it has been reported that a flexible TFT device using an In-Ga-Zn-O (IGZO) oxide semiconductor as a channel layer shows superior characteristics as compared with the case of using a-Si (Non-patent Document 1: Nature, 2004, Vol. 432, p. 488), and utilization thereof as a driving backside board for a liquid crystal display, an organic EL display or the like has been attempted.

There can be mentioned two points in which the IGZO is superior to the above-mentioned a-Si as semiconductor material for TFT devices. One point is that the mobility, which is the most important characteristic of TFT device, of IGZO exceeds 1 cm²/Vsec and is above the mobility value of 0.1 to 1 cm²/Vsec obtainable with a-Si. The other point is that while the a-Si forming process temperature is not lower than 300°C, an IGZO film having the above-mentioned favorable mobility can be obtained even through a non-heating process. Further, IGZO is highly advantageous in that it has a high tendency to maintain an amorphous state, so that stable characteristics can be easily obtained and that it is excellent in film flexibility.

Although IGZO thus has very high performances, however, IGZO is disadvantageous in that it contains harmful Ga, and it needs a very precise control of oxygen content in the film; in other words, IGZO has difficulties in handleability and in control of film formation. Besides, IGZO is disadvantageous in that its composition is complicated because it contains three kinds of metallic elements, and, further, in that its novel introduction into a production line is difficult because it is a material which has not hitherto been handled.

In view of the foregoing, the present applicant has previously developed In-W-O as a semiconductor material which can be comparatively easily formed (shaped) by a non-heating sputtering film-forming method and which has both a high mobility in excess of 1 cm²/Vsec and amorphousness (Patent Document 1: JP-A 2008-192721).

As above-mentioned, this In-W-O film has three great merits, namely, (1) that it has a high mobility in excess of 1 cm²/Vsec, (2) that it can be formed by a non-heating sputtering film-forming method, and (3) that it has amorphousness; thus, the In-W-O film is very useful as a semiconductor film for thin film transistors. However, the characteristics required of semiconductor parts in recent years are extremely high, and it is desired to develop a semiconductor film having a further enhanced mobility. Development of such a semiconductor film ensures that characteristics of a TFT (thin film transistor) can be further enhanced, resulting in that the performance of the device to which the transistor film is applied can also be further enhanced. This simultaneously means that the robustness as a material is expanded and the ease in using the material is enhanced.

Therefore, in order to obtain thin film transistors with higher performance, it is desired to develop a semiconductor film having a further higher mobility, without lowering the characteristic properties possessed by the In-W-O film, such as the property of being able to be formed by a non-heating sputtering film-forming method, the property of having amorphousness, etc.

In addition, in the case where a thin film transistor (TFT) is applied to a backside board for a liquid crystal display or an electronic paper or the like, it suffices to perform n-type driving. In the case where the thin film transistor is applied to driving of display such as a liquid crystal display, an electronic paper, etc., logical circuits such as CMOS, etc. or solar cells or the like, bipolar operations, namely, not only an n-type operation but also a p-type operation are demanded.

In relation to the bipolar operations, Non-patent Document 2: Applied Physics Letters 90, 262104 (2007) discloses an n-type and p-type bipolar transistor based on an organic-inorganic semiconductor structure. In the disclosure, pentacene is used as an organic semiconductor material showing p-type characteristics, while IZO is used as an oxide semiconductor showing n-type characteristics.

On the other hand, the above-mentioned Patent Document 1 discloses a thin film transistor wherein conductivity of a film can be controlled by forming a channel layer from a film of an indium-containing metal oxide such as indium oxide (In₂O₃), tin-doped indium oxide (ITO), or, further, titanium-or tungsten-doped indium oxide (InTiOₓ, InWOₓ), etc.

This time, the present inventors have found out that in the case where pentacene is used as an organic semiconductor material showing p-type characteristics and IZO is used as an oxide semiconductor showing n-type characteristics in the n-type and p-type bipolar transistor of the above-mentioned Non-patent Document 2, pentacene would contaminate IZO as an impurity at the time of film formation, so that the conductivity of IZO would be enhanced, thereby worsening the TFT characteristics.

For obviating this problem, it may be contemplated to control the conductivity of IZO as the oxide semiconductor. However, it is comparatively difficult to control the conductivity of IZO, and, even if the conductivity of IZO is controlled, satisfactory TFT characteristics cannot be obtained.

In view of this, further, an approach may be contemplated in which the inorganic semiconductor material for the bipolar transistor of the organic-inorganic semiconductor structure described in Non-patent Document 2 is formed not of IZO but of the material described in Patent Document 1. However, it has been found that, even in this case, the approach in which the metal oxide film as an inorganic semiconductor is simply formed of the material described in Patent Document 1 results in that the characteristic properties of the metal oxide film would be changed when the organic semiconductor is disposed on the metal oxide film.

Thus, the approach in which the inorganic semiconductor in the bipolar transistor described in Non-patent Document 1 is simply formed of the metal oxide film described in Patent Document 1 cannot cause the transistor to be driven as an n-type and p-type bipolar semiconductor which is sufficiently high in performance and is highly reliable.
Besides, neither Patent Document 1 nor Non-patent Document 1 discloses in any way a bipolar transistor of an organic-inorganic semiconductor structure which has sufficiently high performance and high reliability while maintaining good semiconductor characteristics of characteristics of an oxide semiconductor, in the case where the oxide semiconductor and an organic semiconductor are stacked on each other as above-mentioned.

Furthermore, it has been found that the In-W-O film formed by the non-heating sputtering film-forming method described in the above-mentioned Patent Document 1 has the following three disadvantages.

First of all, the flow rate of oxygen introduced during film formation has a very great influence on the characteristics of the film formed, so that very precise control of the flow rate of oxygen introduced is needed. In addition, it becomes necessary to perform a very subtle control of the flow rate of oxygen introduced, attendant on the progress of erosion of the target. Therefore, it is impossible to easily obtain a TFT device having stable characteristics by a DC sputtering method or RF sputtering method generally used in the prior art, although a favorable film-forming process can be carried out while comparatively easily controlling the oxygen flow rate if a sputtering film-forming apparatus having plasma emission monitor control (PEM control) is used.

Secondly, the states of the interfaces between the semiconductor film surface (channel layer) formed of the above-mentioned In-W-O film and source/drain electrodes and the interface between the semiconductor film surface and the gate insulating film are liable to be instable, so that it is difficult for the characteristics of the TFT device to become stable. Further, thirdly, the above-mentioned In-W-O film is liable to have many defects generated therein, so that it is difficult to obtain stable TFT device characteristics.

In addition, if the second and third problems exist, the transfer characteristic of the TFT device is largely shifted due to bias stress. Therefore, in order to apply the TFT device using the film of the indium-containing metal oxide such as In-W-O as above-mentioned to an actual electronic device, it is indispensable to maintain more stable characteristics, and development of a measure therefor is desired.

### PRIOR ART DOCUMENTS

### PATENT DOCUMENT

- Patent Document 1 :: JP-A 2008-192721

### NON-PATENT DOCUMENTS

- Non-patent Document 1:: Nature, 2004, Vol. 432, p. 488
- Non-patent Document 2:: Applied Physics Letters 90, 262104 (2007)

### SUMMARY OF THE INVENTION

### PROBLEMS TO BE SOLVED BY THE INVENTION

The present invention has been made in consideration of the above-mentioned circumstances. Accordingly, it is a first object of the present invention to develop a semiconductor film which can be formed by a non-heating sputtering film-forming method, has good amorphousness and, further, has a high mobility, and thereby to provide a thin film transistor having higher performance.
In addition, it is a second object of the present invention to construct a bipolar thin film transistor capable of good n-type and p-type bipolar operations, the bipolar thin film transistor having high performance and high reliability while maintaining good semiconductor characteristics of an oxide semiconductor, in the case where a channel layer is formed by stacking the oxide semiconductor and an organic semiconductor.
Further, it is a third object of the present invention to provide a method for manufacturing a thin film transistor by which an indium-containing metal oxide film having stable characteristic properties can be obtained through comparatively easy control while maintaining its characteristic features of being formable by a non-heating sputtering film-forming method and having both high mobility and amorphousness, and by which a TFT device having stable characteristics can be obtained.

### MEANS FOR SOLVING THE PROBLEMS

In order to attain the above objects, the present inventors made earnest investigations. As a result of the investigations, the present inventors found out that metal oxide films of indium oxides (In-W-Zn-O, In-W-Sn-O, In-W-Sn-Zn-O) obtained by further doping tungsten-doped indium oxide (In-W-O) with zinc and/or tin exhibit high mobility in large excess of that of conventional In-W-O, the films can be formed by a favorable non-heating process, and the films have good amorphousness. The present inventors have also found that when a device including a channel layer is formed by use of the metal oxide film, it is possible to comparatively easily fabricate a thin film transistor having high performance.

Accordingly, the present invention provides, as a first-named invention, a thin film transistor including elements including three electrodes of a source electrode, a drain electrode and a gate electrode, as well as a channel layer and a gate insulating film, wherein the channel layer is formed of an indium oxide film doped with tungsten and zinc and/or tin.

In addition, the second object is attained by forming the channel layer from a stack including an organic material film, and a metal oxide film which contains indium doped with at least one of tungsten, tin and titanium and which has an electrical resistivity that is preliminarily controlled.

Accordingly, the present invention provides, as a second-named invention, a bipolar thin film transistor including elements including three electrodes of a source electrode, a drain electrode and a gate electrode, as well as a channel layer and a gate insulating film, wherein the channel layer is a stack including an organic material film, and a metal oxide film which contains indium doped with at least one of tungsten, tin and titanium and which has an electrical resistivity that is preliminarily controlled.

Here, the expression "a metal oxide film which has an electrical resistivity that is preliminarily controlled" means an oxide film of which conductivity is preliminarily controlled before stacking, taking into account the characteristics of the oxide film, so as to maintain good semiconductor characteristics of characteristics of an oxide semiconductor, in the case where a channel layer is formed by stacking the oxide semiconductor and an organic semiconductor.

In addition, in this bipolar thin film transistor, the organic material film is preferably F8T2, P3HT, pentacene, tetrabenzoporphyrin.

The channel layer preferably has the metal oxide and the organic material film stacked in this order from the side of the gate electrode. Besides, the source electrode and the drain electrode are mounted in contact with the organic material film. Incidentally, to make contact with the organic material film means that, when the channel is formed by stacking the metal oxide layer and the organic material layer, the source electrode and the drain electrode are provided on the organic material layer.

In addition, the amount of tungsten contained in the metal oxide film is preferably not less than 0.5 wt% and less than 15 wt%. Further, the electrical resistivity of the metal oxide film is preferably 10⁻¹ to 10⁴ Ωcm.

Further, in order to attain the above third object, the present inventors made earnest investigations. The investigations includes an investigation of the case where sputtering using an indium-containing target is conducted in an oxygen gas-containing atmosphere, whereby an indium-containing metal oxide film is formed in a predetermined pattern on a substrate, and one or more elements including a channel layer or a part of the channel layer in a TFT device are formed from the indium-containing metal oxide film, to thereby manufacture a thin film transistor. As a result of the investigations it was found out that, when a heat treatment is conducted after the formation of the elements of the TFT device by forming the metal oxide film by sputtering in the above-mentioned investigated case, TFT characteristics with stable characteristics and sufficient reproducibility can be obtained, good effects can be obtained through a simple heat treatment in air at a temperature of 150 to 300°C for about 10 to 120 minutes, and excellent productivity is secured.

Accordingly, the present invention provides, as a third-named invention, a method for manufacturing a thin film transistor, including forming on a substrate an indium-containing metal oxide film in a predetermined pattern by sputtering conducted using an indium-containing target in an oxygen gas-containing atmosphere so that one or more elements including at least a channel layer or a part of the channel layer, of elements of the channel layer, a source electrode, a drain electrode and a gate electrode, are formed from the indium-containing metal oxide film, wherein the metal oxide film is formed by conducting the sputtering without heating the substrate, then the elements of the channel layer, the source electrode, the drain electrode and the gate electrode are formed over the substrate, and thereafter a heat treatment is conducted.

In addition, the present inventors advanced the investigations further. As a result of the further investigations, it was found out that, as the indium-containing metal oxide film, it is preferable to form an indium oxide film doped with one or more of tin, titanium, tungsten and zinc by using a sintered body of indium oxide doped with one or more of tin, titanium, tungsten and zinc, as the indium-containing target. Also, it was found out that, particularly in the case where an In-W-Zn-O film is formed by using a sintered body of In-W-Zn-O as a target, TFT characteristics such as threshold voltage and mobility can be easily controlled by controlling the amount of W and the amount of Zn. Further, it was found out that, when a channel layer formed of the In-W-Zn-O film is formed on a substrate composed of a silicon wafer having a thermal oxide film as in Examples to be described later, then an ITO film is formed on the channel layer by use of a sintered body of ITO as a target, thereby forming a source electrode and a drain electrode, and a heat treatment is thereafter conducted, it is possible to obtain a high-performance thin film transistor easily and stably.

Accordingly, the present invention provides, as preferred embodiments of the third-named invention, the inventions of the following paragraphs (1) to (5).
(1) The method for manufacturing the thin film transistor according to the third-named invention above, wherein at least the channel layer or a part of the channel layer is formed by forming an indium oxide film doped with one or more of tin, titanium, tungsten and zinc through using as a target a sintered body of indium oxide doped with one or more of tin, titanium, tungsten and zinc.
(2) The method for manufacturing the thin film transistor according to the paragraph (1), wherein at least the channel layer is formed by forming an In-W-Zn-O film through using as a target a sintered body of In-W-Zn-O.
(3) The method for manufacturing the thin film transistor according to the paragraph (2), wherein control of characteristics is conducted by regulating the W content and/or the Zn content of the sintered body of In-W-Zn-O used as the target.
(4) The method for manufacturing the thin film transistor according to any one of the paragraphs (1) to (3), wherein a silicon wafer having a thermal oxide film to be a gate insulating film is used as a substrate functioning also as the gate electrode, an In-W-Zn-O film is formed on the thermal oxide film of the substrate by use of a sintered body of In-W-Zn-O as a target to thereby form the channel layer, and an ITO film is formed on the channel layer by use of a sintered body of ITO as a target to thereby form the source electrode and the drain electrode.
(5) The method for manufacturing the thin film transistor according to the third-named invention above, wherein the heat treatment is conducted in air at 150 to 300°C for 10 to 120 minutes.

### ADVANTAGEOUS EFFECT OF THE INVENTION

According to the first-named invention, the channel layer is formed from the semiconductor film having attained a higher mobility while maintaining the characteristic features of being formable by a non-heating sputtering film-forming method and having both high mobility and amorphousness, whereby a high-performance thin film transistor can be obtained with high productivity.
In addition, according to the second-named invention, in the thin film transistor wherein the channel layer is formed by stacking an organic material film and a metal oxide film, the metal oxide film includes indium doped with at least one of tungsten, tin, and titanium and has an electrical resistivity that is preliminarily controlled. This configuration ensures that, even in the case where the organic material film is stacked on the metal oxide film, it is possible to provide a bipolar thin film transistor capable of n-type and p-type bipolar operations, the transistor having high performance and high reliability while maintaining good semiconductor characteristics of characteristics of the metal oxide film. Further, it is possible to provide a bipolar thin film transistor which is capable of n-type and p-type bipolar operations and which is low in cost and high in thermal stability.
Furthermore, according to the third-named invention, it is possible to obtain an indium-containing metal oxide film having stable characteristics, through comparatively easy control, while maintaining the characteristic features of being formable by a non-heating sputtering film-forming method and having both high mobility and amorphousness, whereby a TFT device having stable characteristics can be obtained.

### BRIEF DESCRIPTION OF DRAWINGS

[FIG. 1]

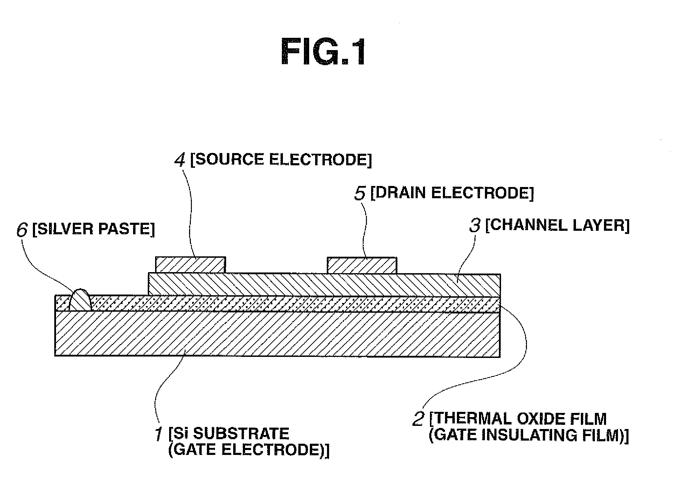

   FIG. 1 is a schematic sectional view showing one example of a TFT device (thin film transistor) according to the first--named invention of the present invention.
[FIG. 2]

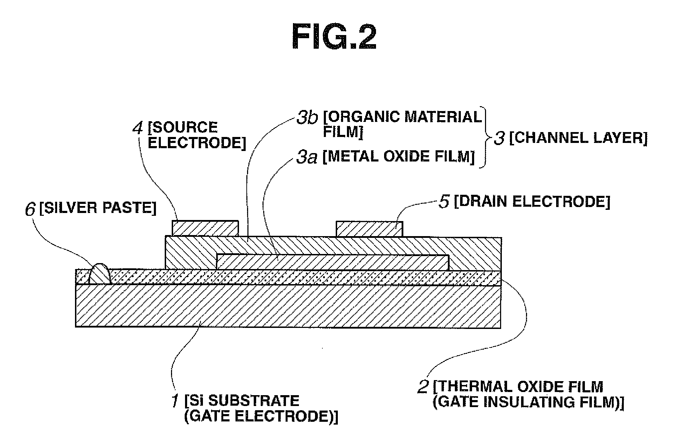

   FIG. 2 is a schematic sectional view showing one example of a TFT device (bipolar thin film transistor) according to the second-named invention of the present invention.
[FIG. 3]

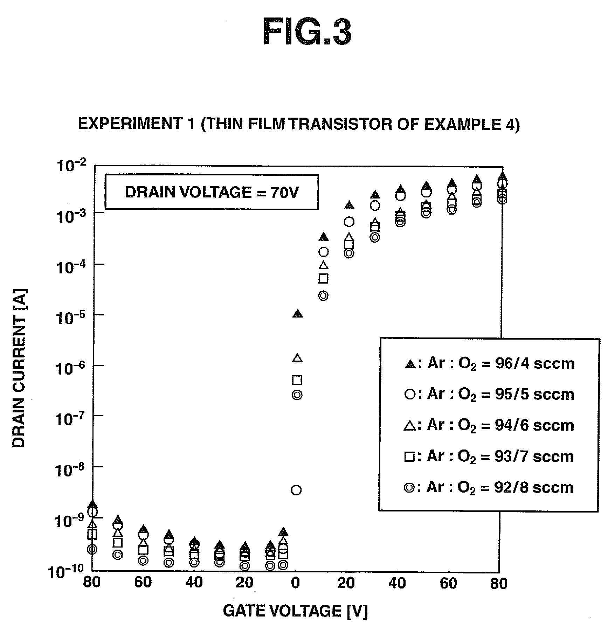

   FIG. 3 is a graph representing operating characteristic of a TFT device (thin film transistor) fabricated in Example 4, showing the results of Experiment 1.
[FIG. 4]

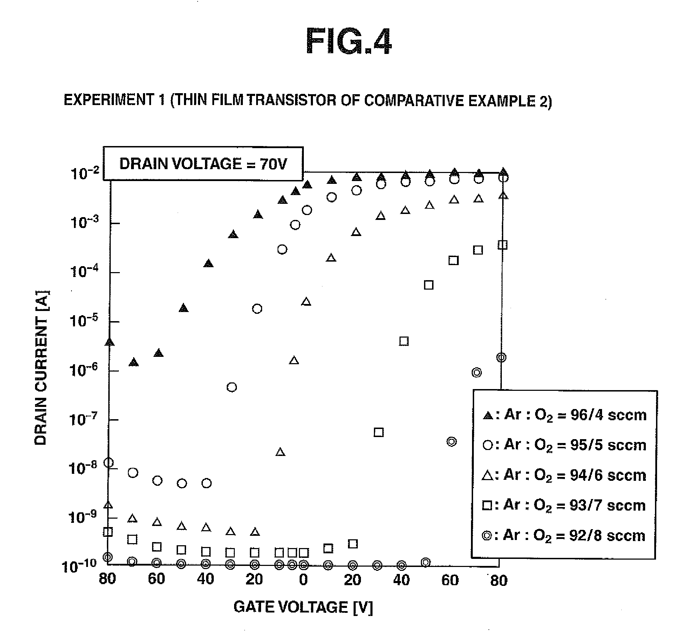

   FIG. 4 is a graph representing operating characteristic of a TFT device (thin film transistor) fabricated in Comparative Example 2, showing the results of Experiment 1.
[FIG. 5]

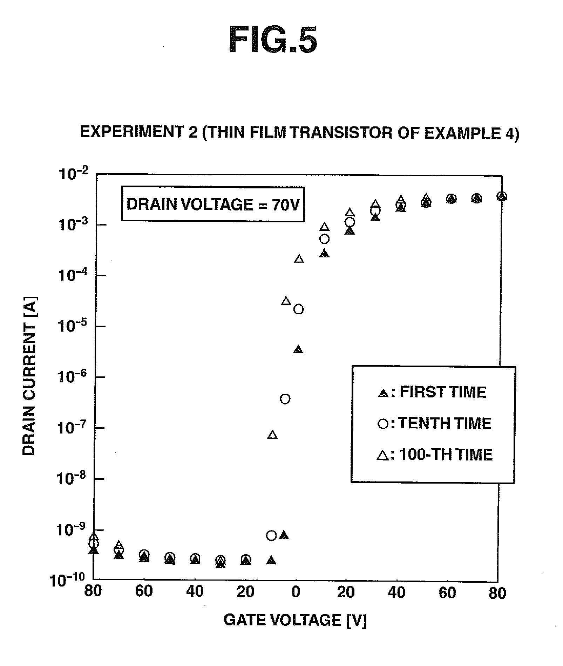

   FIG. 5 is a graph representing operating characteristic of the TFT device (thin film transistor) fabricated in Example 4, showing the results of Experiment 2.
[FIG. 6]

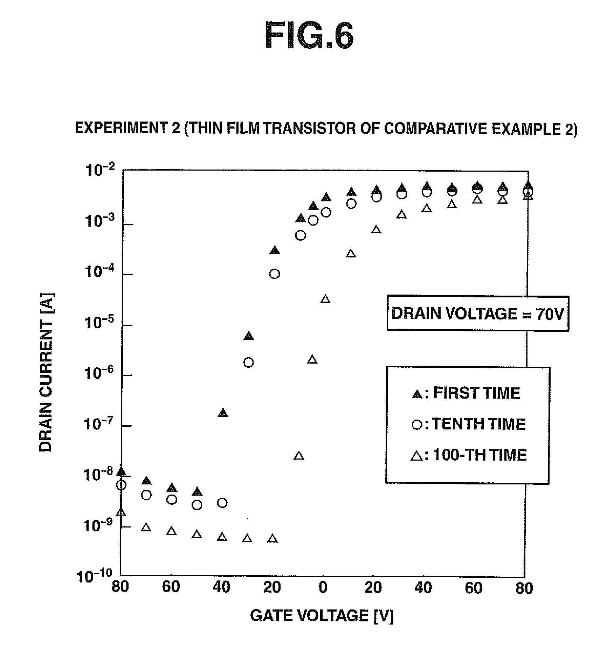

   FIG. 6 is a graph representing operating characteristic of the TFT device (thin film transistor) fabricated in Comparative Example 2, showing the results of Experiment 2.
[FIG. 7]

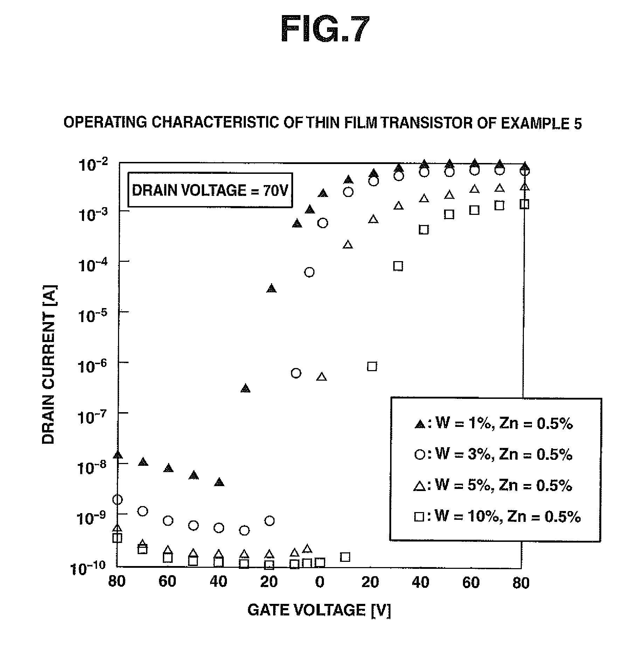

   FIG. 7 is a graph representing operating characteristic of a TFT device (thin film transistor) fabricated in Example 5.
[FIG. 8]

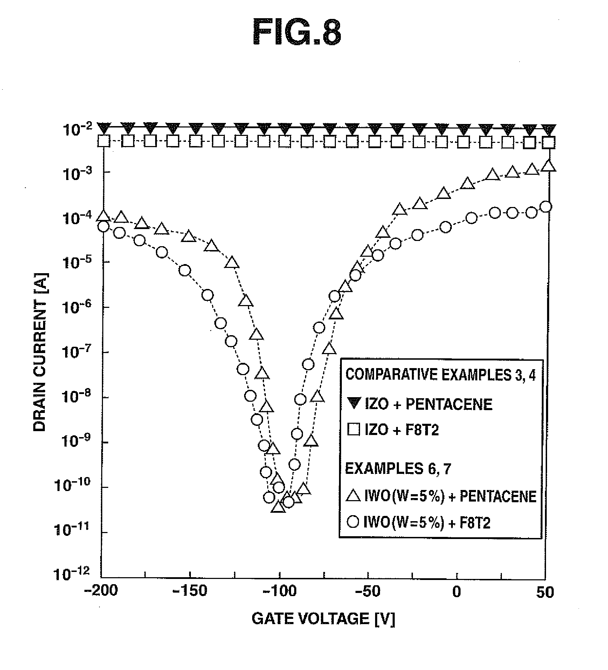

   FIG. 8 is a graph representing operating characteristics of TFT devices (bipolar thin film transistors) fabricated in Examples 6 and 7 and Comparative Examples 3 and 4.
[FIG. 9]

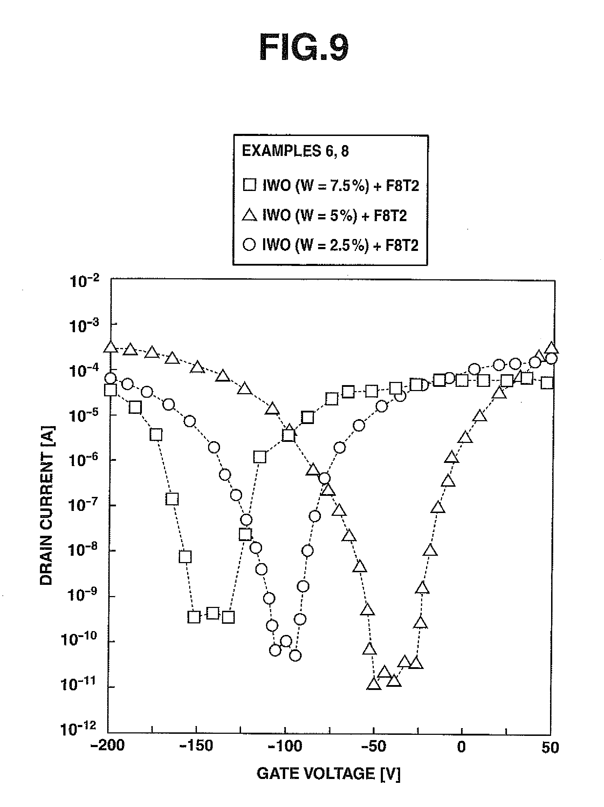

   FIG. 9 is a graph representing operating characteristics of the TFT devices (bipolar thin film transistors) fabricated in Examples 6 and 8.
[FIG. 10]

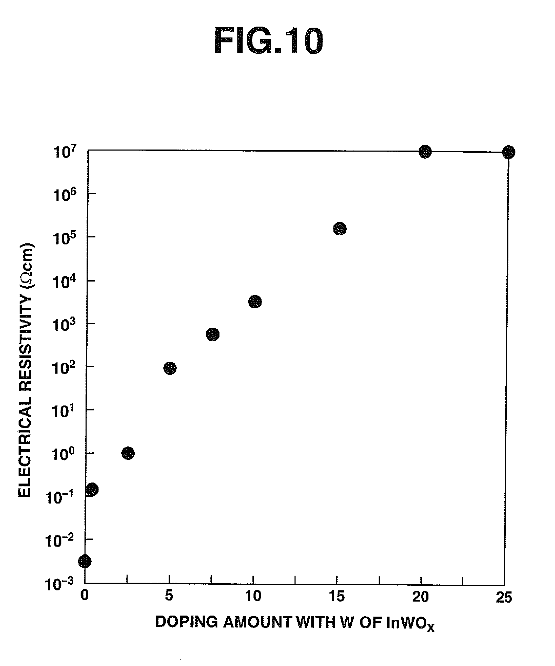

   FIG. 10 is a graph representing the results of the evaluation of characteristics of TFT devices (bipolar thin film transistors) which was conducted in Comparative Example 5.
[FIG. 11]

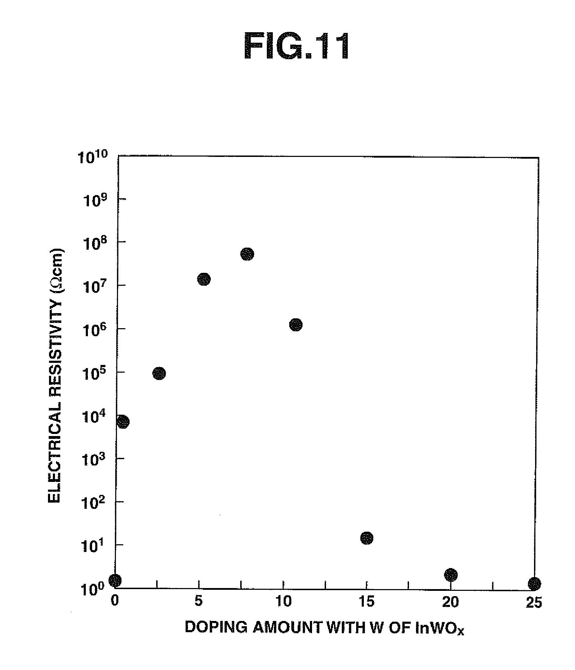

   FIG. 11 is a graph representing the results of the evaluation of characteristics of the TFT devices (bipolar thin film transistors) which was conducted in Comparative Example 5.

### EMBODIMENT FOR CARRYING OUT THE INVENTION

Now, the present invention will be described more in detail below.
The thin film transistor according to the first-named invention, as above-mentioned, is one in which a channel layer is formed of an indium oxide film doped with tungsten and zinc and/or tin, and which can be exemplified by a TFT device of the structure shown in FIG. 1, for example.

The thin film transistor of FIG. 1 is one in which the channel layer 3 is formed on an Si substrate 1 (gate electrode) formed on its surface with a thermal oxide film (SiO₂) as a gate insulating film 2, and, further, a source electrode 4 and a drain electrode 5 are formed on the channel layer 3. In such a thin film transistor, according to the first-named invention, at least the channel layer 3 is formed from an indium-containing metal oxide film. Incidentally, symbol 6 in FIG. 1 denotes a silver paste 6 for conduction with the Si substrate (gate electrode).

The metal oxide film for forming the channel layer 3 is, as above-mentioned, an indium oxide film doped with tungsten and zinc and/or tin; in other words, In-W-Zn-O, In-W-Sn-O or In-W-Sn-Zn-O is used. Each of these indium oxide films can form a transparent conductive film, so that a transparent thin film transistor can be fabricated. In addition, these have a tendency to retain amorphousness and are excellent in thermal stability and film flatness properties. Further, by controlling the W content, Zn content and Sn content of a target in forming these metal oxide films by sputtering, it is possible to easily control the TFT characteristics.

Though not particularly limited, the channel layer 3 has an electrical resistivity which is normally controlled to 10⁻¹ to 10⁶ Ωcm, particularly 1 to 10⁵ Ωcm. In this case, the above-mentioned Tn--W-Zn-O, In-W-Sn-O and In-W-Sn-Zn-O each permit its electrical resistivity to be comparatively easily controlled by controlling the degree of oxygen deficiency at the time of forming the film thereof.

As the film-forming method in the case of forming the channel layer 3 from the In-W-Zn-O film, the In-W-Sn-O film or the In-M-Sn-Zn-O film, there can be used physical vapor deposition methods such as a DC reactive sputtering method, an RF sputtering method, and a pulse laser evaporation method. Particularly, a sputtering method conducted using an indium-containing target in an oxygen gas-containing atmosphere is adopted preferably. In this case, by controllingly varying the flow rate of oxygen gas, the oxygen deficiency of the In-W-Zn-O film, the In-W-Sn-O film or the In-W-Sn-Zn-O film can be controlled, whereby the electrical resistivity of the film can be controlled to the above-mentioned resistivity that is suitable for the channel layer 3.

As the target to be used in forming the film by the sputtering method in this manner, an InWZn metal target and an In-W-Zn-O ceramic target can be used in the case of forming the In-W-Zn-O film, whereas an InWSn metal target and an In-W-Sn-O ceramic target can be used in the case of forming the In-W-Sn-O film, and an InWSnZn metal target and the In-W-Sn-Zn-O ceramic target can be used in the case of forming the In-W-Sn-Zn-O film, respectively.

Here, in forming the indium-containing metal oxide film by the DC reactive sputtering method or the RF sputtering method, in the present invention it is unnecessary to heat the substrate, and the metal oxide film can be favorably formed by conducting the sputtering at normal temperature. In addition, though not particularly restricted, productivity can be enhanced by applying a dual cathode sputtering method in which a pulsed voltage is applied alternately to a plurality of cathodes to thereby form the metal oxide film at high speed. Besides, a feedback system based on PEM (Plasma Emission Monitor) control in which the amount of oxygen introduced is controlled on a real-time basis by measuring the ion concentrations in the plasma may be used, whereby stable control of the composition and the oxygen content of the thin film can be achieved.

In the next place, for the source electrode 4 and the drain electrode 5, there can be used known materials, for example, transparent electrode materials such as In₂O₃, ITO, FTO, In-Ti-O film, In-W-O film, etc., and, if transparency is not demanded, such metallic materials as Au, Pt, Ti, Al, etc., and various conductive polymer materials. Besides, depending on the case, one or both of the source electrode and the drain electrode can be formed of an In-W-Zn-O film, an In-W-Sn-O film or an In-W-Sn-Zn-O film, like the channel layer 3. In this case, the channel layer 3 as well as the source electrode 4 and the drain electrode 5 can be formed by use of the same film-forming apparatus, whereby a reduction in cost can be contrived. In addition, since transparency in the visible light region can be obtained, it becomes possible to cope with a wide range of applications.

The source electrode 4 and the drain electrode 5 are required of good conductivity; normally, these electrodes are controlled to have an electrical resistivity of 10⁻⁵ to 10⁻¹ Ωcm, particularly 10⁻⁵ to 10⁻³ Ωcm. In this case, when the source electrode 4 and the drain electrode 5 are formed by forming an In₂O₃ film, an ITO film, an In-Ti-O film, an In-W-O film, an In-W-Zn-O film, an In-W-Sn-O film, or an In-W-Sn-Zn-O film by the sputtering method like the channel layer 3, such a low resistivity can be attained by controlling the amount of oxygen introduced into the film in such a manner as to positively introduce oxygen deficiency into the film. Besides, it is also effective, in lowering the resistivity, to conduct the film formation while adding hydrogen or water. Further, depending on the case, the formation of these electrodes 4 and 5 can also be conducted by adopting the dual cathode sputtering method or the PEM control, like in the case of the channel layer 3. In this case, stable control of the composition and the oxygen content of the thin film can be conducted, without depending on the state of the target; thus, a film-forming process with high reliability can be performed.

In addition, in the case where the source electrode 4 and the drain electrode 5 are thus formed of the indium-containing metal oxide film by the sputtering method together with the channel layer 3, a compositionally gradient film (graded conductivity film) in which the oxygen content of the film is gradually varied may be formed at the interfaces between the channel layer 3 and each of the source electrode 4 and the drain electrode 5. This ensures that the barrier at the interfaces between the channel layer 3 and each of the source electrode 4 and the drain electrode 5 is reduced, injection of carriers is facilitated, and enhancement of characteristics can be expected.

While the Si substrate having the gate insulating film 2 of SiO₂ has been used as the substrate 1 in the thin film transistor (TFT device) of FIG. 1 above, the substrate is not restricted to this one, and those conventionally known as substrates for electronic devices such as transistors can be used. For instance, other than the Si substrate, there can also be used transparent substrates, e.g., glass substrates such as white sheet glass, blue sheet glass, quartz glass, etc., and polymer film substrates such as polyethylene terephthalate (PET). Further, in the case where transparency is not required of the device, there can be used various metallic substrates, plastic substrates, non-transparent polymer substrates such as polyimide, etc.

Besides, while the Si substrate 1 is made to be a gate electrode and conduction with this gate electrode is secured through the silver paste in the TFT device of FIG. 1 above, an insulating substrate may be used and a gate electrode and a gate insulating film may be separately formed on the substrate.

In this case, as examples of the material for forming the gate electrode, there can be mentioned the same electrode materials as those for the source electrode 4 and the drain electrode 5. Naturally, the gate electrode can be formed by forming an In₂O₃ film, an ITO film, an In-Ti-O film, an In-W-O film, an In-W-Zn-O film, an In-W-Sn-O film, or an In-W-Sn-Zn-O film by use of the same film-forming apparatus as that used at the time of forming the channel layer 3. Incidentally, the electrical resistivity of the gate electrode can be set to be 10⁻⁵ to 10⁻¹ Ωcm, particularly 10⁻⁵ to 10⁻³ Ωcm, like in the case of the source electrode 4 and the drain electrode 5.

In addition, the gate insulating film may be formed by a known method while using a known material such as metal oxides, e.g., SiO₂, Y₂O₃, Ta₂O₅, Hf oxide, etc., or insulating polymer materials, e.g., polyimides. The electrical resistivity of the gate insulating film may be normally 1×10⁶ to 1×10¹⁵ Ωcm, particularly 1×10¹⁰ to 1×10¹⁵ Ωcm.

In the next place, the bipolar thin film transistor according to the second-named invention of the present invention is, for example, a TFT device as shown in FIG. 2, wherein a channel layer 3 is formed of a stack including an organic material film 3b and an indium-containing metal oxide film 3a doped with at least one of tungsten, tin, and titanium.

Here, in FIG. 2, an Si substrate (gate electrode) 1, a thermal oxide film (gate insulating film) 2, a source electrode 4, a drain electrode 5 and a silver paste 6 are the same as in the TFT device of FIG. 1 which has been shown as an example of the thin film transistor according to the first-named invention. Further, the layout configuration of these elements with the channel layer 3 is also the same as in the TFT device of FIG. 1. Besides, in the bipolar thin film transistor according to the second-named invention, as above-mentioned, the channel layer 3 is formed of a stacked structure of the organic material film 3b and the metal oxide film 3a.

In the thin film transistor according to the third-named invention wherein the channel layer 3 is thus formed by stacking the organic material film 3b and the metal oxide film (inorganic material film) 3a, the metal oxide film 3a is formed to include indium doped with at least one of tungsten, tin, and titanium (InWOₓ, InSnOₓ, InTiOₓ).

Further preferably, the metal oxide film 3a is formed to include indium doped with tungsten and at least one of tin, titanium, and zinc (InWSnO, InWTiO, InWZnO).

The use of such a material ensures that electrical resistivity can be comparatively easily controlled by controlling the degree of oxygen deficiency and the amount of doping with tungsten, at the time of forming the metal oxide film 3a. For example, if IZO is used as the metal oxide film 3a like in the prior art, the conductivity of the film becomes too high, resulting in that at the time of stacking the organic material film 3b on the IZO of the metal oxide film 3a, the characteristic properties of the metal oxide film 3a located on the lower side would be changed greatly. As a result, even if the metal oxide film 3a as an n-type and the organic material film 3b as a p-type are stacked, both the n-type and p-type polarities cannot be sufficiently driven in the condition where TFT characteristics are not much changed. On the other hand, when the metal oxide film 3a is set to contain any of the above-mentioned materials as in the present invention, it is possible to control the resistivity of the metal oxide film 3a and thereby to control the conductivity of the film. Therefore, taking into account the change in characteristics of the metal oxide film 3a upon stacking the organic material film 3b, it is possible to preliminarily control, prior to the stacking, the conductivity of the metal oxide film 3a so that the film will have a desired resistivity. By thus setting the resistivity to a somewhat higher value through controlling the amount of oxygen introduced and the amount of doping with tungsten, it is possible to ensure that the semiconductor characteristics of good characteristics of the metal oxide film 3a can be maintained, in other words, TFT characteristics can be maintained in good condition, after the organic material film 3b is formed on the metal oxide film 3a. Accordingly, it is possible to construct a bipolar thin film transistor which is capable of bipolar operations and which has both high performance and high reliability. In addition, when such a material as above-mentioned is used, a transparent conductive film can be obtained and, therefore, a transparent thin film transistor can be fabricated.

Besides, particularly when the metal oxide film 3a is made to contain tungsten-doped indium without fail, the conductivity of the metal oxide film can be controlled more effectively. Here, in semiconductor devices such as TFTs, a heating step for adhesion to a panel, for sealing step or the like is always needed as a post-step in the process of completing the products. After the post-annealing (described later) as the heating step is carried out, the conductivity of the metal oxide film depends on only the amount of doping with tungsten.

Specifically, before annealing, the conductivity of IWO depends on both the amount of oxygen introduced and the amount of doping with tungsten. After the post-annealing, however, the oxygen content of the metal oxide film comes to rest in a thermodynamically stable state, so that the conductivity comes to be independent from the amount of oxygen introduced at the time of film formation. Thus, when the metal oxide film is made to necessarily contain tungsten-doped indium, it is ensured that even in the case where a heating treatment such as post-annealing is conducted, the conductivity of the film can be controlled by varying the amount of doping with tungsten.

Incidentally, in the bipolar transistor of the organic-inorganic semiconductor structure using IZO as the inorganic semiconductor material that is disclosed in the above-mentioned Non-patent Document 2, the conductivity of the inorganic semiconductor material would become too strong after post-annealing, so that this material would be unable to function as a semiconductor. On the other hand, according to the bipolar transistor of the organic-inorganic semiconductor structure of the present invention using the above-mentioned material as the inorganic semiconductor material, the conductivity of the inorganic semiconductor material would not become too strong even after post-annealing, so that this material can function as a semiconductor. In semiconductor devices such as TFT, as above-mentioned, a heating step for adhesion to a panel, for sealing step or the like is always needed as a post-step in the process of completing the products. Therefore, when the above-mentioned material is used as the inorganic semiconductor material, it is possible to obtain a highly thermally stable transistor which can retain the function as semiconductor even in the case where a heating treatment such as post-annealing is conducted.

As above-mentioned, when the metal oxide film 3a is made to contain tungsten-doped indium without fail, the resistivity of the metal oxide film 3a can be controlled more easily and more accurately. This ensures that before stacking the metal oxide film 3a as the channel layer, it is possible to form the metal oxide film 3a that has a desired resistance for offering good TFT characteristics. Besides, particularly, InWOₓ, InWSnO, InWTiO, and InWZnO, which contain tungsten, have the tendency to retain amorphousness and, hence, are excellent in thermal stability and film flatness properties.

Here, the amount of tungsten contained in the metal oxide film 3a is preferably not less than 0.6 wt% and less than 15 wt%, based on the whole part of the metal oxide film. If the tungsten content reaches or exceeds 15 wt%, the resistivity would become too high to make the film insulating, so that it may be impossible to maintain good TFT characteristics.

In addition, though not particularly restricted, the metal oxide film 3a of the channel layer 3 has an electrical resistivity that is normally controlled to 10⁻¹ to 10⁵ Ωcm, particularly 1 to 10⁴ Ωcm. In this case, the above-mentioned InWOₓ, InSnOₓ, InTiOₓ, and further preferably InWSnO, InWTiO, and InWZnO permit the electrical resistivity to be comparatively easily controlled by controlling the degree of oxygen deficiency at the time of film formation.

With such an electrical resistivity secured, it is ensured that even where the organic material film 3b is stacked on the metal oxide film 3a, characteristic properties of the metal oxide film would not be changed, and good TFT characteristics can be maintained. As a result, n-type and p-type bipolar operations can be driven in the condition where high performance and reliability are secured.

For forming the metal oxide film 3a for forming a part of the channel layer 3, specifically, the above-mentioned InWOₓ film, InSnOₓ film, InTiOₓ film, or further preferably InWSnO film, InWTiO film, or InWZnO film, there can be used physical vapor deposition methods such as a DC reactive sputtering method, an RF sputtering method, a pulse laser evaporation method, etc. like in the case of the first-named invention. Particularly, it is preferable to adopt a sputtering method conducted using an indium-containing target in an oxidizing gas-containing atmosphere. In this case, by controlling the flow rate of oxygen gas, it is possible to control the oxygen deficiency amount of the metal oxide film (InWOₓ film, InSnOₓ film, InTiOₓ film, InWSnO film, InWTiO film, InWZnO film). Therefore, even where the channel layer 3 is formed by stacking the organic material film 3b on the metal oxide film 3a, it is possible to prevent the characteristic properties of the metal oxide film 3a from being changed greatly. In other words, even where the organic material film 3b is further stacked on the metal oxide film 3a, the electrical resistivity of the metal oxide film 3a can be controlled to a resistivity suitable for the channel layer 3. Consequently, n-type and p-type bipolar operations can be driven in good conditions.

As the target to be used at the time of forming the metal oxide film by the sputtering method, an InW metal target and an InWOₓ ceramic target can be used in the case of forming the InWOₓ film, whereas an InTi metal target and an InTiOₓ ceramic target can be used in the case of forming the InTiOₓ film, and an InSn metal target and an InSnOₓ ceramic target can be used in the case of forming the InSnOₓ film.

Incidentally, the conventional film-forming method such as the DC reactive sputtering method and the RF sputtering method has a problem in that, due to comparatively low rate of film formation, it may be impossible to obtain sufficient productivity. It has another problem in that, since stable composition control for the InWOₓ film, InSnOₓ film, InTiOₓ film, InWSnO film, InWTiO film or InWZnO film is not easy to achieve, it may be difficult to maintain characteristics. In view of this, though not particularly restricted, the dual cathode sputtering method may be applied so as to enhance productivity, like in the case of the first-named invention. Further, it is preferable to use a feedback system based on the above-mentioned PEM (Plasma Emission Monitor) control, whereby stable control of the composition and the oxygen content of the thin film can be performed independently from the state of the target.

In the next place, the organic material layer 3b for forming a part of the channel layer 3 is formed of F8T2, P3HT, pentacene, or tetrabenzoporphyrin. However, the material to be used is not limited to these materials, and the organic material film 3b may be formed of any of those general materials which are used as organic material semiconductor in transistors. Incidentally, the method for forming the organic material film 3b constituting a part of the channel layer 3 is not specifically restricted, and the film may be formed by a known method. For instance, a spin coating method is used suitably.

In addition, as shown in FIG. 2, the channel layer 3 configured by a stack of the metal oxide film 3a and the organic material film 3b is preferably formed by stacking the metal oxide film 3a and the organic material film 3b in this order from the gate electrode 1 side (the lower side in FIG. 2). In this case, as above-mentioned, the metal oxide film 3a is formed particularly by a sputtering method; on the other hand, the organic material film 3b can be formed by vapor deposition, but is preferably formed particularly by a spin coating method, from the viewpoint of cost reduction. Therefore, if the organic material film 3b is formerly formed on the gate electrode 1, the organic material film 3b may be altered (denatured) by exposure to plasma during the sputtering for forming the metal oxide film 3a; besides, a large amount of the organic material may be mixed into the metal oxide film 3a. It should be noted here, however, that the channel layer 3 in the TFT device according to the third-named invention is not restricted to the stacked form having the metal oxide film 3a as the lower layer and the organic material film 3b as the upper layer as shown in FIG. 2. By a contrivance as to the stacking method, a stacked form can be adopted in which the organic material film 3b is the lower layer and the metal oxide film 3a is the upper layer.

Further, the source electrode 4 and the drain electrode 5 are preferably formed in contact with the upper surface of the organic material film 3b. With both the electrodes thus formed on the organic material film 3b, there is obtained an effect such that contact resistance is greatly reduced, and good TFT characteristics can be obtained. Then, from this viewpoint, also, the channel layer 3 is preferably formed by stacking the metal oxide film 3a and the organic material film 3b in this order from the gate electrode 1 side (the lower side in FIG. 2).

In the next place, the source electrode 4 and the drain electrode 5 can be formed from the same material and in the same manner as in the case of the above-described first-named invention. Particularly, it is preferable to form one or both of the electrodes from an indium-containing metal oxide film such as InWOₓ, InSnOₓ, InTiOₓ, InZnOₓ, InWSnO, InWTiO, InWZnO, etc., like the metal oxide film 3a of the channel layer 3. This enables the metal oxide film 3a of the channel layer 3, the source electrode 4 and/or the drain electrode 5 to be formed by the same film-forming apparatus, so that manufacturing cost can be lowered.

The conductivities of the source electrode 4 and the drain electrode 5 are also controlled to an electrical resistivity of normally 10⁻⁵ to 10⁻¹ Ωcm, particularly 10⁻⁵ to 10⁻² Ωcm, like in the case of the above-described first-named invention. In this case, when the source electrode 4 and the drain electrode 5 are formed from an InWOₓ film, InSnOₓ film, InTiOₓ film, InZnOₓ film, InWSnO film, InWTiO film, InWZnO film or the like, the electrodes can be formed by a sputtering method, like in the case of forming the metal oxide film 3a constituting a part of the channel layer 3. In this instance, also, by controlling the amount of oxygen introduced into the film so as to introduce oxygen deficiency into the electrodes, it is possible to achieve a low resistivity, like in the case of the first-named invention. Besides, the effect of forming the film while adding hydrogen or water and the effect of adoption of the dual cathode sputtering method or the PEM control are the same as in the case of the first-named invention.

Further, the substrate 1, the thermal oxide film 2, the silver paste 6 and the like are the same as in the first-named invention described above, so that the same reference symbols as in FIG. 1 are used in FIG. 2, and descriptions of these elements are omitted.

Incidentally, the thin film transistors according to the first-named invention and the second-named invention are not restricted to the bottom-gate top-contact type ones shown in FIGS. 1 and 2, respectively. The thin film transistors may take other forms, such as bottom-gate bottom-contact type, top-gate bottom-contact type, top-gate top-contact type, etc.

In the next place, as above-mentioned, the method for manufacturing a thin film transistor according to the third-named invention includes forming on a substrate an indium-containing metal oxide film by sputtering so that one or more elements including at least a channel layer or a part of the channel layer, of elements of the channel layer, a source electrode, a drain electrode and a gate electrode, are formed from the indium-containing metal oxide film, and conducting a heat treatment after formation of these elements.

Here, the thin film transistor to be manufactured in the present invention is not specifically restricted. Examples of the thin film transistor include the thin film transistor of the first-named invention that is shown in FIG. 1, and the bipolar thin film transistor of the second-named invention that is shown in FIG. 2.

Besides, in the manufacturing method in the present invention, the channel layer 3 (FIG. 1) or the metal oxide film 3a (FIG. 2) of the channel layer 3 is formed on the substrate 1 by forming the indium-containing metal oxide film by the above-mentioned sputtering method, further, the source electrode 4 and the drain electrode 5 and, further, depending on the TFT structure, the above-mentioned gate electrode, are formed to thereby form the elements of the TFT device, and thereafter the heat treatment is conducted.

The heating temperature in conducting the heat treatment is appropriately set according to the kind, size, thickness, etc. of the metal oxide film for forming the channel 3 (FIG. 1) or the metal oxide film layer 3a (FIG. 2) constituting a part of the channel layer 3, and is not particularly limited; normally, the heating temperature may be 150 to 300°C, particularly 150 to 200°C. The treatment time may be 10 to 120 minutes, particularly 30 to 60 minutes. In addition, as the atmosphere for the heating treatment, the atmospheric air may be adopted without any problem.

In the present invention, by conducting the heat treatment, particularly by applying the heat treatment to the In-W-Zn-0 film, the following three effects can be obtained.
Firstly, even in the case where the amount of oxygen introduced at the time of film formation by sputtering is not an optimum value and satisfactory TFT characteristics cannot necessarily be obtained, the TFT characteristics can be brought into an optimal state by the heat treatment. Therefore, it becomes unnecessary to subtly control the quantity of oxygen introduced, attendant on the progress of erosion of the sputtering target. In addition, variations in TFT characteristics which might arise from the degree of vacuum reached during film formation by sputtering are eliminated, so that a TFT device with stable characteristics can be easily manufactured.

Secondly, defects at interfaces or in the semiconductor film are decreased greatly, and variations in characteristics during use as the TFT device are reduced extremely.
Further, thirdly, by controlling the W content and/or the Zn content of the target to be used for film formation by sputtering, TFT characteristics such as threshold voltage and mobility can be easily controlled.

### EXAMPLES

Now, the present invention will be describe more specifically below by showing Examples and Comparative Examples, but the invention is not to be restricted to the following Examples.

### Examples 1 to 3, Comparative Example 1

### [Performance Test of Semiconductor Films]

First, performances of an In-W-Zn-O film, an In-W-Sn-O film and an In-W-Sn-Zn-O film used as a channel layer in a thin film transistor pertaining to a first-named invention of the present invention were evaluated in the following manner.

### Preparation of test sample

### (Sample 1 : In-W-Zn-O film)

On a 1.1 mm-thick quartz glass substrate cleaned with ethanol and acetone, a 30 nm-thick In-W-Zn-O film was formed by a DC magnetron sputtering process in the condition where the substrate was not heated. The sputtering conditions were as follows.

| (Sputtering Conditions) | |
|---|---|
| Target: | Sintered body of In-W-Zn-O |
| | (W = 5 wt%, Zn = 0.5 wt%, size 75 mmφ) |
| Degree of vacuum reached: | 1.0x10⁻³ Pa |
| Pressure during film formation: | 0.5 Pa |
| Power applied: | 150 W |
| Sputtering time: | about 5 minutes |
| Gas flow rates during film formation: | Ar/O₂ = 94/6.0 sccm |

From the quartz glass substrate thus formed thereon with the In-W-Zn-O film, a 10 mm × 10 mm specimen was formed by cutting. A shadow mask was adhered to the specimen so as to hide a central portion of the specimen, and ohmic electrodes composed of a 30 nm-thick ITO film were formed on the four corners of the specimen by a DC magnetron sputtering process, to obtain Sample 1. The sputtering conditions were as follows.

| (Sputtering Conditions) | |
|---|---|
| Target: | Sintered body of In-Sn-O |
| | (Sn = 5 wt%, size 75 mmφ) |
| Degree of vacuum reached: | 1.0×10⁻³ Pa |
| Pressure during film formation: | 0.5 Pa |
| Power applied: | 150 W |
| Sputtering time: | about 3 minutes |
| Gas flow rates during film formation: | Ar/O₂ = 99/1.0 sccm |

### (Sample 2: In-W-Sn-O film)

On a 1.1 mm-thick quartz glass substrate cleaned with ethanol and acetone, a 30 nm-thick In-W-Sn-O film was formed by a DC magnetron sputtering process in the condition where the substrate was not heated. The sputtering conditions were as follows.

| (Sputtering Conditions) | |
|---|---|
| Target: | Sintered body of In-W-Sn-O |
| | (W = 5 wt%, Sn = 0.5 wt%, size 75 mmφ) |
| Degree of vacuum reached: | 1.0×10⁻³ Pa |
| Pressure during film formation: | 0.5 Pa |
| Power applied: | 150 W |
| Sputtering time: | about 5 minutes |
| Gas flow rates during film formation: | Ar/O₂ = 94/6.0 sccm |

From the quartz glass substrate thus formed thereon with the In-W-Sn-O film, a 10 mm × 10 mm specimen was formed by cutting. Ohmic electrodes composed of an ITO film were formed on the four corners of the specimen in the same manner as in the case of Sample 1 above, to obtain Sample 2.

### (Sample 3: In-W-Sn-Zn-O film)

On a 1.1 mm-thick quartz glass substrate cleaned with ethanol and acetone, a 30 nm-thick In-W-Sn-Zn-O film was formed by a DC magnetron sputtering process in the condition where the substrate was not heated. The sputtering conditions were as follows.

| (Sputtering Conditions) | |
|---|---|
| Target: | Sintered body of |
| | In-W-Sn-Zn-O (W = 5 wt%, Zn = 0.25 wt%, Zn = 0.25 wt%, size 75 mmφ) |
| Degree of vacuum reached: | 1.0×10⁻³ Pa |
| Pressure during film formation: | 0.5 Pa |
| Power applied: | 150 W |
| Sputtering time: | about 5 minutes |
| Gas flow rates during film formation: | Ar/O₂ = 94/6.0 sccm |

From the quartz glass substrate thus formed thereon with the In-W-Sn-Zn-O film, a 10 mm × 10 mm specimen was formed by cutting. Ohmic electrodes composed of an ITO film were formed on the four corners of the specimen in the same manner as in the case of Sample 1 above, to obtain Sample 3.

### (Sample 4: In-W-O film)

On a 1.1 mm-thick quartz glass substrate cleaned with ethanol and acetone, a 30 nm-thick In-W-O film was formed by a DC magnetron sputtering process in the condition where the substrate was not heated. The sputtering conditions were as follows.

| (Sputtering Conditions) | |
|---|---|
| Target: | Sintered body of In-W-O |
| | (W = 5 wt%, size 75 mmφ) |
| Degree of vacuum reached: | 1.0×10⁻³ Pa |
| Pressure during film formation: | 0.5 Pa |
| Power applied: | 150 W |
| Sputtering time: | about 5 minutes |
| Gas flow rates during film formation: | Ar/O₂ = 94/6.0 sccm |

From the quartz substrate thus formed thereon with the In-W-O film, a 10 mm × 10 mm specimen was formed by cutting. Ohmic electrodes composed of an ITO film were formed on the four corners of the specimen in the same manner as in the case of Sample 1 above, to obtain Sample 4.

For Samples 1 to 4 above, Hall measurement was conducted by the Van der Pauw method. The Hall measurement was carried out using a Hall measurement system "ResiTest 8300" made by Toyo Corp. The results are shown in Table 1.

**Table 1**

| | Semiconductor film | Resistivity (Ωcm) | Carrier concentration (cm⁻³) | Hall mobility (cm²/Vs) |
|---|---|---|---|---|
| Sample 1 | In-W-Zn-O | 4.7×10 | 3.4×10¹⁸ | 3.89 |
| Sample 2 | In-W-Sn-O | 5.9 | 1.7×10¹⁷ | 6.22 |
| Sample 3 | In-W-Sn-Zn-O | 1.9×10 | 6.9×10¹⁸ | 4.98 |
| Sample 4 | In-W-O | 2.9×10² | 1.9×10¹⁶ | 1.15 |

As shown in Table 1, it has been verified from the results of the Hall measurement that the In-W-Zn-O film, the In-W-Sn-O film and the In-W-Sn-Zn-O film obtained by doping the In-W-O film further with Zn and/or Sn have a largely enhanced Hall mobility.

### Example 1

On a silicon wafer formed on its surface with a thermal oxide film (SiO₂, 300 nm thick) as a gate insulating film, a 30 nm-thick In-W-Zn-O film was formed as a channel layer by a DC magnetron sputtering process. In this case, the sputtering conditions were set to be the same as in forming the In-W-Zn-O film of Sample 1 above, and the sputtering was conducted without heating the substrate.

On the channel layer obtained as above, a 30 nm-thick ITO film was formed as a source electrode and a drain electrode by a DC magnetron sputtering process, to fabricate a thin film transistor (TFT device) configured as shown in FIG. 1. In this case, the sputtering conditions were set to be the same as in forming the ohmic electrodes of Sample 1 above. In forming the source electrode and the drain electrode, patterning was conducted using a shadow mask so as to obtain a channel length of 0.1 mm and a channel width of 6.4 mm.

### Example 2

On a silicon wafer formed on its surface with a thermal oxide film (SiO₂, 300 nm thick) as a gate insulating film, a 30 nm-thick In-W-Sn-O film was formed as a channel layer by a DC magnetron sputtering process. In this case, the sputtering conditions were set to be the same as in forming the In-W-Sn-O film of Sample 2 above, and the sputtering was carried out without heating the substrate.

On the channel layer thus obtained, a 30 nm-thick ITO film was formed as a source electrode and a drain electrode by a DC magnetron sputtering process, to fabricate a thin film transistor (TFT device) configured as shown in FIG. 1. In this case, the sputtering conditions were set to be the same as in forming the ohmic electrodes of Sample 2 above. In forming the source electrode and the drain electrode, pattering was performed using a shadow mask in the same manner as in Example 1 above, so as to obtain a channel length of 0.1 mm and a channel width of 6.4 mm.

### Example 3

On a silicon wafer formed on its surface with a thermal oxide film (SiO₂, 300 nm thick) as a gate insulating film, a 30 nm-thick In-W-Sn--Zn-O film was formed as a channel layer by a DC magnetron sputtering process. In this case, the sputtering conditions were set to be the same as in forming the In-W-Sn-Zn-O film of Sample 3 above, and the sputtering was conducted without heating the substrate.

On the channel layer thus obtained, a 30 nm-thick ITO film was formed as a source electrode and a drain electrode by a DC magnetron sputtering process, to fabricate a thin film transistor (TFT device) configured as shown in FIG. 1. In this case, the sputtering conditions were set to be the same as in forming the ohmic electrodes of Sample 3 above. In forming the source electrode and the drain electrode, patterning was conducted using a shadow mask in the same manner as in Example 1 above, so as to obtain a channel length of 0.1 mm and a channel width of 6.4 mm.

### Comparative Example 1

On a silicon wafer formed on its surface with a thermal oxide film (SiO₂, 300 nm thick) as a gate insulating film, a 30 nm-thick In-W-O film was formed as a channel layer by a DC magnetron sputtering process. In this case, the sputtering conditions were set to be the same as in forming the In-W-O film of Sample 4 above, and the sputtering was carried out without heating the substrate.

On the channel layer thus obtained, a 30 nm--thick ITO film was formed as a source electrode and a drain electrode by a DC magnetron sputtering process, to fabricate a thin film transistor (TFT device) configured as shown in FIG. 1. In this case, the sputtering conditions were set to be the same as in forming the ohmic electrodes of Sample 4 above. In forming the source electrode and the drain electrode, patterning was performed using a shadow mask in the same manner as in Example 1 above, so as to obtain a channel length of 0.1 mm and a channel width of 6.4 mm.

For the four kinds of thin film transistors obtained in Examples 1 to 3 and Comparative Example 1 above, TFT characteristics were evaluated using a semiconductor parameter analyzer "4155C" made by Agilent Technologies. In this instance, the drain voltage was 70 V, and the gate electrode was swept over the range of -70 to +70 V. From the TFT characteristics thus obtained, field effect mobility µ_{FE} was calculated. The results are shown in Table 2.

**Table 2**

| | Semiconductor film for forming channel layer | Field effect mobility (cm²/Vs) | ON/OFF ratio | Threshold voltage (V) |
|---|---|---|---|---|
| Example 1 | In-W-Zn-O | 3.23 | 1.1×10³ | +3.3 |
| Example 2 | In-W-Sn-O | 7.19 | 5.4×10⁷ | -7.1 |
| Example 3 | In-W-Sn-Zn-O | 5.63 | 7.5×10⁷ | -3.7 |
| Comparative Example 1 | In-W-O | 1.36 | 1.2×10⁸ | +5.4 |

As shown in Table 2, it has been verified that the thin film transistors (Examples 1 to 3) pertaining to the first-named invention of the present invention wherein the channel layer is composed of the In-W-Zn-O film, the In-W-Sn-O film or the In-W-Sn-Zn-O film obtained by doping the In-W-O film further with Zn and/or Sn show a largely enhanced field effect mobility, as compared with the thin film transistor (Comparative Example 1) wherein the In-W-O film is used as the channel layer.

### Example 4

In the same manner as in Example 1, a 30 nm-thick In-W-Zn-O film was formed on a silicon wafer as a channel layer. In this instance, the quantity of oxygen introduced during film formation was varied as follows, to form five kinds of In-W-Zn-O films.

### Gas flow rates during film formation

(1) Ar/O₂ = 96/4.0 sccm
(2) Ar/O₂ = 95/5.0 sccm
(3) Ar/O₂ = 94/6.0 sccm
(4) Ar/O₂ = 93/7.0 sccm
(5) Ar/O₂ = 92/8.0 sccm

On each of the channel layers thus obtained, a 30 nm-thick ITO film was formed as a source electrode and a drain electrode in the same manner as in Example 1, so as to fabricate thin film transistors (TFT devices) configured as shown in FIG. 1.

After the formation of the source electrode and the drain electrode, the thin film transistors were heat treated in air at 150°C for 30 min, to fabricate five kinds of thin film transistors.

### Comparative Example 2

Five kinds of thin film transistors were fabricated in the same manner as in Example 1, except that the final heat treatment was not conducted.

### [Experiment 1]

For the thin film transistors obtained respectively in Example 4 and Comparative Example 2 above, TFT characteristics were evaluated using a semiconductor parameter analyzer "4155C" made by Agilent Technologies. The results for the thin film transistor of Example 4 above are represented by the graph in FIG. 3, while the results for the thin film transistor of Comparative Example 2 are represented by the graph in FIG. 4.

The thin film transistor of Example 4 above and the thin film transistor of Comparative Example 2 above are compared with each other in regard of transfer characteristic. As shown in FIG. 4, the transfer characteristic of the thin film transistor of Comparative Example 2 which was manufactured by the method without any heat treatment varies greatly depending on the quantity of oxygen introduced during formation of the In-W-Zn-O film. On the other hand, as shown in FIG. 3, the transfer characteristic of the thin film transistor of Example 4 which was manufactured with the final heat treatment is little affected by variations in the quantity of oxygen introduced during formation of the In-W-Zn-O film; thus, it is recognized that TFT characteristics are little dependent on variations in the quantity of oxygen introduced during the film formation.

These results indicate that according to the manufacturing method of the present invention in which a heat treatment is finally carried out, it is possible to obtain a thin film transistor having stable TFT characteristics independently of the quantity of oxygen introduced during formation of a semiconductor film.

### [Experiment 2]

The thin film transistors fabricated respectively in Example 4 and Comparative Example 2 above, by setting the quantity of oxygen introduced during formation of the In-W-Zn-O film so that Ar/O₂ = 94/6.0 sccm, were each put to successive 100 runs of measurement of transfer characteristic in the same manner as in Experiment 1, and comparison was made in regard of the measurement results obtained respectively at the 1st, 10th and 100th runs of measurement. The results for the thin film transistor of Example 4 are represented by the graph in FIG. 5, while the results for the thin film transistor of Comparative Example 2 are represented by the graph in FIG. 6.

As shown in FIGS. 5 and 6, the transfer characteristic of the thin film transistor obtained by the method of Example 4 showed little shift in threshold voltage even when the measurement was repeated 100 times (FIG. 5). On the other hand, the transfer characteristic of the thin film transistor obtained by the method of Comparative Example 2 showed a large shift, toward the minus side, in threshold voltage as the measurement was repeated.

### Example 5

Under the following sputtering conditions, a channel layer composed of an In-W-Zn-O film was formed on a silicon wafer in the same manner as in Example 1, under the following sputtering conditions. In this case, as the target composed of a sintered body of In-W-Zn-O, four kinds of targets differing in W content as indicated by the following sputtering conditions were used, to form four kinds of In-W-Zn-O films.

| (Sputtering Conditions) | | |
|---|---|---|
| Target: | (1) Sintered body | of In-W-Zn-O (W = 1 wt%, Zn = 0.5 wt%, size 75 mmφ) |
| | (2) Sintered body | of In-W-Zn-O (W = 3 wt%, Zn = 0.5 wt%, size 75 mmφ) |
| | (3) Sintered body | of In-W-Zn-O (W = 5 wt%, Zn = 0.5 wt%, size 75 mmφ) |
| | (4) Sintered body | of In-W-Zn-O (W = 10 wt%, Zn = 0.5 wt%, size 75 mmφ) |
| Degree of vacuum reached: | | 1.0×10⁻³ Pa |
| Pressure during film formation: | | 0.5 Pa |
| Power applied: | | 150 W |
| Sputtering time: | | about 5 minutes |
| Gas flow rates during film formation: | | Ar/O₂, = 94/6.0 sccm |

On each of the channel layers thus obtained, a source electrode and a drain electrode composed of an ITO film were formed in the same manner as in Example 1, followed by a heat treatment in air at 150°C for 30 min in the same manner as in Example 1, to fabricate four kinds of thin film transistors. For each of the thin film transistors thus obtained, measurement of transfer characteristic was conducted to evaluate TFT characteristics, in the same manner as in Experiment 1 above. The results are represented by the graph in FIG. 7.

As shown in FIG. 7, it was verified that TFT characteristics vary continuously with W content of the sintered body of In-W-Zn-O used as the target. It is recognized in this case that the threshold voltage is shifted toward the plus side as the W content increases, showing that the quantity of carriers in the semiconductor film (channel layer) depends on the W content of the target.

Accordingly, it has been verified that TFT characteristics can be easily controlled by regulating the W content of the target in forming the In-W-Zn-O film.

### Example 6

First, on a silicon wafer formed on its surface with a thermal oxide film (SiO₂) as a gate insulating film, a 30 nm-thick film of InWO oxide semiconductor was formed. The film formation was conducted by a sputtering method under the following conditions.

| <Sputtering Conditions> | |
|---|---|
| Target: | InWO ceramic target (size 75 nmφ) |
| Composition of InWO ceramic target: | In/W = 95/5 wt% |
| Pressure during film formation: | 0.5 Pa |
| Power applied to target: | 150 W |
| Substrate used: | Silicon wafer (300 nm thick) with thermal oxide film |
| Quantities of gas introduced during film formation: | Ar/O₂ = 95/5 sccm |
| Film formation time: | 150 seconds |

Subsequently, the InWO film thus formed was coated with a p-type organic semiconductor. The coating was conducted by spin coating under the following conditions.

| <Spin Coating Conditions> | |
|---|---|
| Organic semiconductor used: | F8T2 |
| Solvent: | chloroform |
| Solvent concentration: | 2 mg/ml |
| Spinner rotating speed: | 1000 rpm |
| Rotation time: | 10 seconds |
| Drying conditions: | 60°C × 10 minutes |

### <Fabrication of Source/Drain Electrodes>

Further, on the channel layer formed of the InWO oxide semiconductor and the p-type organic semiconductor prepared as above, source/drain electrodes having a stack of 3 nm-thick Cr and 45 nm-thick Au were formed by a sputtering method. Patterning was conducted by a known method using a shadow mask. Besides, the channel length was set to 0.1 mm, and the channel width was set to 6.4 mm.

### <Annealing>

Furthermore, the thus obtained element was heat treated in air at 150°C for one hour, to obtain a bipolar thin film transistor (TFT device) having the same configuration as in FIG. 2.

### Example 7

On a silicon wafer formed on its surface with a thermal oxide film (SiO₂) as a gate insulating film, a 30 nm-thick film of InWO oxide semiconductor was formed. The film formation was conducted by a sputtering method under the following conditions.

| <Sputtering Conditions> | |
|---|---|
| Target: | InWO ceramic target (size 75 nmφ) |
| Composition of InWO ceramic target: | In/W = 95/5 wt% |
| Pressure during film formation: | 0.5 Pa |
| Power applied to target: | 150 W |
| Substrate used: | Silicon wafer (300 nm thick) with thermal oxide film |
| Quantities of gas introduced during film formation: | Ar/O₂ = 95/5 sccm |
| Film formation time: | 150 seconds |

Subsequently, a film of a p-type organic semiconductor was formed on the thus formed InWO film by a vapor deposition method. The vapor deposition conditions were as follows.

### <Vapor Deposition Conditions>

Organic semiconductor used: pentacene
Degree of vacuum reached: below 1×10⁻⁴ Pa
Film thickness: about 50 nm

### <Fabrication of Source/Drain Electrode, Annealing>

In the same manner as in Example 6, source/drain electrodes were formed and, thereafter, a heat treatment was conducted, to obtain a bipolar thin film transistor (TFT device) having the same configuration as in FIG. 2.

### Comparative Example 3

On a silicone wafer formed on its surface with a thermal oxide film (SiO₂) as a gate insulating film, a 30 nm-thick film of InZnO oxide semiconductor was formed. The film formation was carried out by a sputtering method under the following conditions.

| <Sputtering Conditions> | |
|---|---|
| Target: | InZnO ceramic target (size 75 nmφ) |
| Composition of InZnO ceramic target: | In/Zn = 95/5 wt% |
| Pressure during film formation: | 0.5 Pa |
| Power applied to target: | 150 W |
| Substrate used: | Silicon wafer (300 nm thick) with thermal oxide film |
| Quantities of gas introduced during film formation: | Ar/O₂ = 95/5 sccm |
| Film formation time: | 150 seconds |

The thus formed InZnO film was coated with a p-type organic semiconductor. The coating was conducted by spin coating under the following conditions.

| <Spin Coating Conditions> | |
|---|---|
| Organic semiconductor used: | F8T2 |
| Solvent: | chloroform |
| Solvent concentration: | 2 mg/ml |
| Spinner rotating speed: | 1000 rpm |
| Rotation time: | 10 seconds |
| Drying conditions: | 60°C × 10 minutes |

### <Fabrication of Source/Drain Electrodes, Annealing>

In the same manner as in Example 6, source/drain electrodes were formed and, thereafter, a heat treatment was conducted, to obtain a bipolar thin film transistor (TFT device).

### Comparative Example 4

### <Sputtering Conditions>

On a silicon wafer formed on its surface with a thermal oxide film (SiO₂ as a gate insulating film, a 30 nm-thick film of InZnO oxide semiconductor was formed. The film formation was conducted by a sputtering method under the following conditions.

| <Sputtering Conditions> | |
|---|---|
| Target: | InZnO ceramic target (size 75 nmφ) |
| Composition of InZnO ceramic target: | In/Zn = 95/5 wt% |
| Pressure during film formation: | 0.5 Pa |
| Power applied to target: | 150 W |
| Substrate used: | silicon wafer (300 nm thick) with thermal oxide film |
| Quantities of gas introduced during film formation: | Ar/O₂ = 95/5 sccm |
| Film formation time: | 150 seconds |

### <Vapor Deposition Conditions>

Subsequently, a film of a p-type organic semiconductor was formed on the thus formed InZnO film by a vapor deposition method. The vapor deposition conditions were as follows.

| <Vapor Deposition Conditions> | |
|---|---|
| Organic semiconductor used: | pentacene |
| Degree of vacuum reached: | below 1×10⁻⁴ Pa |
| Film thickness: | about 50 nm |

### <Fabrication of Source/Drain Electrodes, Annealing>

In the same manner as in Example 6, source/drain electrodes were fabricated and, thereafter, a heat treatment was conducted, to obtain a bipolar thin film transistor (TFT device).

For the TFT devices fabricated as above, a TFT characteristic evaluation experiment was conducted by using a semiconductor parameter analyzer 4155C made by Agilent Technologies and by sweeping the gate voltage over the range of -200 V to +50 V while applying a drain voltage of +50 V. FIG. 8 shows the evaluation results of TFT characteristics.

As seen in FIG. 8, the results of the TFT characteristic evaluation experiment show that in Example 6, holes accumulated in the p-type organic semiconductor flowed as carriers and hence a p-type operation was exhibited when the gate voltage was in the range of -200 V to -110 V. Besides, when the gate voltage was in the range of -90 V to 50 V, electrons accumulated in the n-type oxide semiconductor layer composed of the InWO film flowed as carriers and hence an n-type operation was exhibited. The range from -110 V to -90 V corresponds to an OFF state. Thus, it was verified that in the TFT device wherein a multilayer film having both an n-type oxide semiconductor and F8T2, which is a p-type organic semiconductor, is used to form the channel, both n-type and p-type polar operations can be realized by forming an InWO film as the n-type oxide semiconductor.
In addition, in Example 7 also, substantially the same results were exhibited. Specifically, it was confirmed that in the TFT device wherein a multilayer film having both an n-type oxide semiconductor and pentacene, which is a p-type organic semiconductor, is used to form the channel, both n-type and p-type polar operations can be realized by forming an InWO film as the n-type oxide semiconductor.

On the other hand, in Comparative Examples 3 and 4, not any modulation was found applicable. This is because the InZnO film was turned wholly into a conductor by the annealing.

### Example 8

In forming the film of the InWO oxide semiconductor in Example 6, the film formation was conducted by varying the amount of doping with tungsten.
In the same manner as in Example 6, a 30 nm-thick film of InWO oxide semiconductor was formed on a silicon wafer formed on its surface with a thermal oxide film (SiO₂) as a gate insulating film. In the same manner as in Example 6 except for the difference in tungsten content, the film formation was conducted by a sputtering method under the following conditions.

| <Sputtering Conditions> | |
|---|---|
| Target: | InWO ceramic target (size 75 nmφ) |
| Composition of InWO ceramic target: | |
| | In/W = 97.5/2.5 wt% |
| | In/W = 92.5/7.5 wt% |
| Pressure during film formation: | 0.5 Pa |
| Power supplied to target: | 150 W |
| Substrate used: | silicon wafer (300 nm thick) with thermal oxide film |
| Quantities of gas introduced during film formation: | Ar/O₂ = 95/5 sccm |
| Film formation time: | 150 seconds |

The InWO film thus formed was spin coated with a p-type organic semiconductor in the same manner as in Example 6. Further, in the same manner as in Example 6, source/drain electrodes were fabricated and, thereafter, a heat treatment was conducted, to obtain a bipolar thin film transistor (TFT device).

For the TFT devices fabricated as above, a TFT characteristic evaluation experiment was conducted by using a semiconductor parameter analyzer 4155C made by Agilent Technologies and by sweeping the gate voltage over the range of -200 V to +50 V while applying a drain voltage of +50 V. FIG. 9 shows evaluation results of TFT characteristics obtained in Example 6 (△) and Example 8 (□, ○).

As seen in FIG. 9, the results of the TFT characteristic evaluation test show that in the case where the amount of doping with tungsten was set greater, the characteristics of the bipolar transistor obtained were better. Besides, in this case, the OFF voltage was nearer to 0 V, which indicates that the device is easier to use. In addition, the OFF current was smaller, showing that a higher ON/OFF ratio can be secured. Specifically, in the case where the composition of the InWO ceramic target was set so that In/W = 92.5/7.5 wt%, the characteristics of the bipolar transistor were better, as compared with Example 6 in which In/W = 95/5 wt%.

### Comparative Example 5

In the same manner as in Example 8, in forming the film of the InWO oxide semiconductor of Example 6, the film formation was conducted by varying the amount of doping with tungsten, and the relationships of the amount of doping with tungsten with electrical resistivity of the InWO thin film, and with the characteristics of the bipolar transistor of the present invention, were examined.

First, FIG. 10 shows the relationship between the amount of doping with tungsten and electrical resistivity of the InWO thin film. Here, InWO films varied in the amount of doping with tungsten were each formed on a quarts glass under the following sputtering conditions, which are the same as in Example 6.

| <Sputtering Conditions | |
|---|---|
| Target: | InWO ceramic target (size 75 nmφ) |
| Composition of InWO ceramic target: | |
| | In/W = 100/0 wt% |
| | In/W = 99.5/0.5 wt% |
| | In/W = 97.5/2.5 wt% |
| | In/W = 95/5 wt% |
| | In/W = 92.5/7.5 wt% |
| | In/W = 90/10 wt% |
| | In/W = 85/15 wt% |
| | In/W = 80/20 wt% |
| | In/W = 75/25 wt% |
| Pressure during film formation: | 0.5 Pa |
| Power applied to target: | 150 W |
| Quantities of gas introduced during film formation: | |
| | Ar/O₂ = 95/5 sccm |
| Film formation time: | 150 seconds |
| Film thickness: | 30 nm |

The films thus obtained were heat treated in air at 150°C, for annealing, and were subjected to measurement of resistivity by use of a Hall measurement system ResiTest 8300 made by Toyo Corp.
As a result, as shown in FIG. 10, good semiconductor-like resistivity was obtained when the amount of doping with tungsten was not less than 0.5 wt% and less than 15 wt%. It is seen that in the films doped with not less than 15 wt% of tungsten, the resistivity is not less than 10⁵ Ωm, indicating that the insulating property is so high that the films are unsuitable as a semiconductor film for use in TFT. Also, it is clear that the films not containing tungsten at all are too high in conductivity.

Further, these InWO films were each formed on a silicon wafer provided thereon with a thermal oxide film, in the same manner as in Examples 6 and 8, to fabricate bipolar transistors. Incidentally, the spin coating conditions, the fabrication of source/drain electrodes, and annealing were the same as in Example 6.

For the TFT devices fabricated, evaluation of TFT characteristics was conducted by using a semiconductor parameter analyzer 4155C made by Agilent Technologies and by sweeping the gate voltage over the range of -200 V to +50 V while applying a drain voltage of +50 V.

FIG. 11 is a diagram in which the ON/OFF ratio obtained by comparing the current in an OFF state with the current in an ON state when the gate voltage is +50 V is plotted as dependency on the amount of doping with tungsten, based on the results obtained above.
As is seen from these results, a sufficient ON/OFF ratio can be obtained in the case where the amount of doping with tungsten is not less than 0.5 wt% and less than 15 wt%. On the other hand, when the amount of doping with tungsten was less than 0.5 wt%, the InWO film became a perfect conductor, and the TFT device was always in the ON state, so that the ON/OFF ratio was 1. On the contrary, when the amount of doping with tungsten was not less than 15 wt%, the resistivity of InWO was too high, so that the TFT device was always in the OFF state, and it was almost impossible to obtain a substantial ON/OFF ratio.

### EXPLANATION OF REFERENCE NUMERALS

1: Substrate (Gate electrode)
2: Gate insulating film
3: Channel layer
3a: Metal oxide film
3b: Organic material film
4: Source electrode
5: Drain electrode
6: Silver paste

## Claims

1. A thin film transistor comprising elements including three electrodes of a source electrode, a drain electrode and a gate electrode, as well as a channel layer and a gate insulating film, wherein the channel layer is formed of an indium oxide film doped with tungsten and zinc and/or tin.

2. The thin film transistor according to claim 1, wherein the indium oxide film doped with tungsten and zinc and/or tin is formed by sputtering a target containing indium and tungsten and zinc and/or tin in a oxygen gas-containing atmosphere.

3. The thin film transistor according to claim 1 or 2, wherein each of the elements is obtained by forming a film by sputtering without heating a substrate on which to form the film and without conducting an annealing treatment after the film formation.

4. A bipolar thin film transistor comprising elements including three electrodes of a source electrode, a drain electrode and a gate electrode, as well as a channel layer and a gate insulating film,
wherein the channel layer is a stack including
an organic material film, and
a metal oxide film which contains indium doped with at least one of tungsten, tin and titanium and which has an electrical resistivity that is preliminarily controlled.

5. The bipolar thin film transistor according to claim 4, wherein the organic material film contains any of F8T2, P3HT, pentacene, and tetrabenzoporphyrin.

6. The bipolar thin film transistor according to claim 4 or 5, wherein the channel layer has the metal oxide film and the organic material film stacked in this order from the side of the gate electrode.

7. The bipolar thin film transistor according to claim 6, wherein the source electrode and the drain electrode are mounted in contact with the organic material film.

8. The bipolar thin film transistor according to any one of claims 4 to 7, wherein the metal oxide film contains not less than 0.5 wt% and less than 15 wt% of tungsten.

9. The bipolar thin film transistor according to any one of claims 4 to 8, wherein the electrical resistivity of the metal oxide film is 10⁻¹ to 10⁴ Ωcm.

10. A method for manufacturing a thin film transistor, comprising forming on a substrate an indium-containing metal oxide film in a predetermined pattern by sputtering conducted using an indium-containing target in an oxygen gas-containing atmosphere so that one or more elements including at least a channel layer or a part of the channel layer, of elements of the channel layer, a source electrode, a drain electrode and a gate electrode, are formed from the indium-containing metal oxide film,
wherein the metal oxide film is formed by conducting the sputtering without heating the substrate, then the elements of the channel layer, the source electrode, the drain electrode and the gate electrode are formed over the substrate, and thereafter a heat treatment is conducted.

11. The method for manufacturing the thin film transistor according to claim 10, wherein at least the channel layer or a part of the channel layer is formed by forming an indium oxide film doped with one or more of tin, titanium, tungsten and zinc through using as a target a sintered body of indium oxide doped with one or more of tin, titanium, tungsten and zinc.

12. The method for manufacturing the thin film transistor according to claim 11, wherein at least the channel layer or a part of the channel layer is formed by forming an In-W-Zn-O film through using as a target a sintered body of In-W-Zn-O.

13. The method for manufacturing the thin film transistor according to claim 12, wherein control of characteristics is conducted by regulating the W content and/or the Zn content of the sintered body of In-W-Zn-O used as the target.

14. The method for manufacturing the thin film transistor according to any one of claims 11 to 13, wherein a silicon wafer having a thermal oxide film to be a gate insulating film is used as a substrate functioning also as the gate electrode, an In-W-Zn-O film is formed on the thermal oxide film of the substrate by use of a sintered body of In-W-Zn-O as a target to thereby form the channel layer, and an ITO film is formed on the channel layer by use of a sintered body of ITO as a target to thereby form the source electrode and the drain electrode.

15. The method for manufacturing the thin film transistor according to any one of claims 10 to 14, wherein the heat treatment is conducted in air at 150 to 300°C for 10 to 120 minutes.
